Europäisches Patentamt

European Patent Office

Office européen des brevets

(19)

(11) Publication number:

**0 336 684**

**A2**

(12)

# EUROPEAN PATENT APPLICATION

(21) Application number: **89303278.9**

(51) Int. Cl.⁴: **H 03 H 21/00**

(22) Date of filing: **03.04.89**

(30) Priority: **08.04.88 GB 8808209**

(43) Date of publication of application:
**11.10.89 Bulletin 89/41**

(84) Designated Contracting States:
**AT BE CH DE ES FR GR IT LI LU NL SE**

(71) Applicant: **CEDAR AUDIO LIMITED**
**Botolph House 16 Botolph Lane**
**Cambridge (GB)**

(72) Inventor: **Rayner, Peter John Wynn**
**69 High Street**
**Oakington Cambridge (GB)**

(74) Representative: **Nash, Keith Wilfrid et al**
**KEITH W. NASH & Co. Pearl Assurance House 90-92**
**Regent Street**
**Cambridge CB2 1DP (GB)**

(54) **Noise reduction in the playback of recorded sound.**

(57) A method of noise reduction wherein two versions of the same original signal, for exmple of a recording, are simultaneously processed, one being supplied to a digital filter and the other to a component to which the filter ouptut is fed to produce an error signal, and the error signal is processed by a microprocessor programmed with an adaptive algorithm and fed back to vary the characteristics of the filter in such a manner as to reduce the error signal to a minimum, whereupon the digital filter provides the enhanced signal.

EP 0 336 684 A2

## Description

## Noise Reduction in the Playback of Recorded Sound

### Field of Invention

This invention concerns methods and apparatus for the reduction of unwanted spurious noise during the playing of recordings (such as records or film tracks) in which at least two different copies of an original recording are available.

The invention is also applicable to noise reduction where two signals are available which have been transmitted along different paths and have therefore been subjected to different random noise.

### Background to the Invention

Impulsive and white noise are two of the most common types of degradation of archived recordings. The disturbances on different copies of a recording are usually uncorrelated with each other.

Previous attempts to reduce such noise have not been particularly successful and it is an object of the present invention to provide an improved method and apparatus for achieving such noise reduction and enhancement of archived recordings.

Since the process can be used wherever two signals are available which are derived from our original source but via different transmission paths, the invention is obviously of more general application than the enhancement of archived recordings. This description should therefore be read in this light.

### Summary of the Invention

According to one aspect of the present invention in a method of noise reduction, two versions of the same original signal (eg records, film sound tracks, cylinder recordings or transmissions) are processed simultaneously one incoming signal by a digital filter (such as a Finite Impulse Response filter or a low pass analogue filter) the output of which is compared with the other incoming signal so as to give an error signal corresponding to the difference between the output of the filter and the other incoming signal, the error signal is processed by a microprocessor programmed with an adaptive algorithm so as to vary the characteristics of the digital or analogue filter in a manner to shift the filtered signal in time so as to reduce the error signal to a minimum; the output of the digital filter providing the noise reduced and enhanced signal.

For correct operation the filter should not have to introduce a delay into the filtered signal greater than the filter length. Additional relative delay may therefore be provided by the insertion of pure delay devices in one or other of the inputs so as to maintain the relative delay within the filter length.

For optimum operation the delay introduced by the digital filter should be approximately one half of the filter length.

Where pure delays are inserted, the filter coefficients of the digital filter must be shifted in appropriate direction to avoid undesirable transients.

The filter coefficients of the digital filter are adapted such that the mean squared error is minimised. The tap delay at which the filter coefficients have a maximum value, gives the relative delay to the nearest integer accuracy. For a more accurate estimation of the delay, a quadratic interpolater can be used to determine values from the three points at and around the maximum.

The performance of the digital filter as an interpolater is a function of the Band limitedness, input signal correlation structure, sample spacing, relative delay, fractional delay and the filter length N. This performance improves with increasing sampling rate, filter length and the correlation between successive data samples. The interpolation error increases as the fractional part of the delay approaches half sample spacing and decreases as the integer part of the delay approaches half filter length.

It can be shown mathematically that for the error signal power to be a minimum, the digital filter must be adapted so as to pass as much of the original signal as possible and block as much noise as possible. This arises basically from the fact that the digital filter is operating on only one channel of the information and since the noise in the other signal in the other channel is not affected by variations in the filter coefficients of the digital filter, the minimum value achievable for the error signal will be the noise component of the signal in the channel which is not affected by the digital filter.

A suitable algorithm for implementation of the least squares filter is the LMS or the RLS algorithm. The advantage of the LMS algorithm is its computational simplicity. The main drawback however is that the algorithm performs poorly when the input signal has a large Eigenvalue spread, as is the case with speech and music. A solution to this problem is to model this signal as the output of an autoregressive system excited with a flat spectrum excitation. In such an arrangement the signal is decomposed into the autoregressive parameters and the relatively white excitation. The adaptive noise suppression is performed on the excitation signal. When audio signals are decomposed into the autoregressive model parameters and the excitation signal, white noise disturbances corrupt the excitation more than the autoregressive model parameters. Therefore restoration of the excitation signal leads to considerable improvement in the overall signal to noise ratio. The main disadvantage of this method however is that transforming the noisy signal to noisy excitation reduces the signal to noise ratio at the resonant frequencies.

On the other hand the RLS algorithm is not sensitive to Eigenvalue spread but has a computational complexity considerably greater than the LMS algorithm. This makes its use prohibitive for the application in which the filter length is in the range 50 to 400. Fast RLS algorithms have been used for the implementation of the algorithm described in the paper entitled "Fast recursive least squares transversal filters for adaptive filtering" in IEEE transactions ASSP volume 32 pages 304 to 337 April 1984. However this fast algorithm is sensitive to numerical inaccuracies. The problem becomes worse when the input signals are noisy in which event two improvements may be made to improve stability namely to use a near to optimal initial condition (which may be obtained by use of the LMS or previous use of the Fast algorithm), and secondly the algorithm may be periodically re-initialised, although the re-initialisation period must take place well before the filter coefficients become corrupted. Typically the filter tap coefficients immediately before re-initialisation are used as the initial conditions.

The invention relies for its success on the fact that the random noise tends to be relatively small amplitude relative to the amplitude excursions of the speech or music signals which are to be found on archived recordings, and tend to require a very high band width for satisfactory transmission. By using an adaptive algorithm to control the digital filtering of the signal and optimising the difference between the corrected signal and another signal, arising from the same source but having different noise components, means that the original noise components in the first signal can be largely eradicated since they can be accurately identified as an error signal since they will normally not occur at the same instant in time as the noise spikes in the reference signal.

The invention however is not particularly suited to handling large amplitude noise spikes such as might occur in the event that a record is cracked or large blemishes appear in the sound track of a film. To this end impulse noise detection and suppression should be provided before the adaptive noise suppression circuit of the invention and reference is here made to our copending Patent Application which describes an impulsive noise detection and suppression system in which the Impulsive noise is smeared to a scaled version of the impulsive response of an inverse filter whereas the desired signal samples are transformed back to the uncorrelated excitation samples. The samples which are obliterated by impulses are discarded and the gaps are filled using signals generated using an autoregressive model based interpolation algorithm.

By using an impulsive noise detection and suppression circuit, the noise signal level in the signal finally delivered to the adaptive noise suppression circuit of the invention can be wholly accommodated within the capabilities of the latter circuit enabling the latter to function at optimum efficiency.

The invention will now be described by way of example with reference to the accompanying drawing in which:

Figure 1 illustrates an adaptive noise suppression system embodying the invention and

Figure 2 illustrates an impulsive noise detection system which may be used to supply signals to the digital filter of the circuit shown in Figure 1.

Figures 3 to 6 illustrate signals at different points in the impulse noise detection and suppression system of Figure 2 and

Figures 7 to 9 illustrate signals at different points in the adaptive noise suppression system of Figure 1.

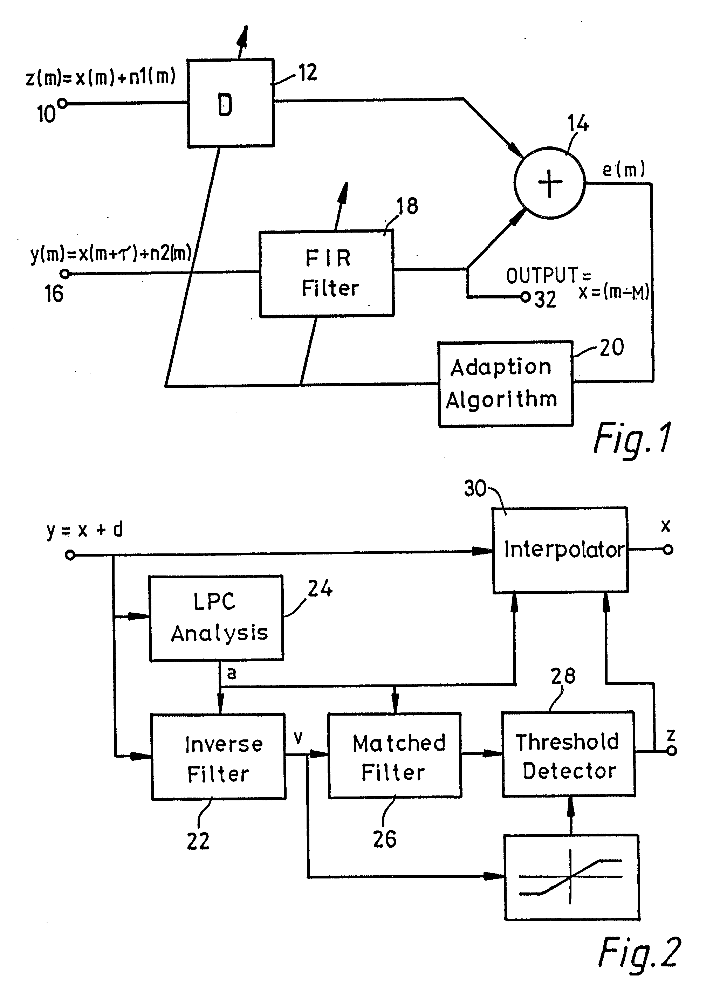

In Figure 1 two inputs are provided for two symbols z(n) and y(n), derived from two simultaneously played recordings of the same original speech or music. The signal z(n) at input 10 is delayed by an adjustable pure delay line 12 and the signal provides one input to an adding stage adder 14. The second input 16 is connected to the input of a digital filter 18 (a finite impulse response filter as shown in Figure 1) the output of which provides the enhanced audio signal x(m-M) and which also supplies the same signal to the inverting input of the adding stage 14.

The error signal output e(m) from the adding stage 14 is supplied to a microprocessor 20 programmed with an adaption algorithm for controlling the values of the coefficients of the digital filter 18 and the amount of delay introduced by the delay device 12. The adaption algorithm operates so as to adjust the filter coefficients such that the mean squared error signal (the output from adding stage 14) is minimised.

The varience of the error signal e(m) is given by the following expression namely:-

$$E(e^2_m) = E((Z_m-W^TY_{m-M}))$$
$$= S^2 + (S_x^2 + W^TRw-2w^Tr) + (w^TNw)$$

Where $r = (r_{(r+M)}, r_{(r+M-1)}, r_{(r+M-2)}...r_{(r+M-N+1)})$ $S_x^2$ is the signal power

$S^2$ is the noise power,

R is the input signal correlation matrix,

N is the noise autocorrelation matrix,

$r_m$ is the signal correlation lag,

M is the number of unit delays inserted.

For the sum of the terms within the first bracket to be a minimum the filter must pass as much of the original signal as possible whereas for the second term to have a minimum value, the filter must block as much noise as possible.

Figure 2 illustrates schematically an impulse noise detection and elimination system. In this system which is described more fully in our copending application for Impulse noise detection and suppression, the incoming noisy signal y is sampled, and samples are only replaced by the median value by the interpolater, if the difference between the sampled value and the median value is greater than some threshold. Since impulsive noise corrupts only a fraction of the original signal, it is necessary to detect and correct individual impulses in order to avoid the unnecessary processing and consequente loss of noiseless samples. The incoming noisy signal is filtered by an inverse filter 22 controlled by the output from the LPC analysis stage 24, and the filtered output provides the input to a matched filter 26 also controlled by the LPC analysis circuit.

The output from the matched filter 26 is applied to the input of a threshold detector whose threshold is controlled by the output from the inverse filter 22.

An interpolater 30 interpolates between sample values where the threshold detector indicates such a large departure from the median value as to suggest the sample value includes an impulsive noise component.

The interpolater 30 is thus controlled by the output from the LPC analysis circuit 24, and the threshold detector 28, so that sample values of the incoming noisy signal which very substantially and suddenly depart from immediately preceding values are compressed by being replaced with the interpolated median value.

Speech and music signals are characterised by the existance of high Q resonances and transforming a noisy signal to the excitation space has the following effects that:

a) The scale of the desired signal is reduced to almost that of the original excitation whereas the scale of impulsive noise is not reduced. This is mainly due to the fact that an autoregressive system is usually a good model of correlated signals whereas it cannot adequately model impulsive disturbances. This can result in significant enhancement of impulsive noise relative to desired signal.

b) The impulsive noise is smeared to a scaled version of the impulse response of the inverse filter, whereas the desired signal samples are transformed back to the uncorrelated excitation samples. A filter, matched to the inverse filter impulse response, therefore optimally detects impulsive disturbances. It can be shown mathematically that there are essentially three factors which contribute to the noise in the excitation sequence estimate. These are (A) the impulsive noise itself, (B) the effect of the past p noise samples smeared to the present time by the action of the inverse filtering, and (C) the inflation in the variance of the excitation signal caused by the error in the parameter vector estimation. Transforming the noisy signal to the excitation space effectively reduces the scale of the signal to almost that of the original excitation whereas the scale of the noise remains the same or increases. It can be shown that the improvement in the signal to noise ratio entirely depends on the autoregressive model parameters and is given by the spectral energy of the autoregressive system given by the expression "Impulsive noise to excitation ratio"/"Impulsive noise to signal ratio".

For speech and music signals the scale of the amplitude of the noiseless excitation signal is usually of the order of one tenth to one thousandth that of the signal. Transforming the noisy signal to excitation space therefore improves the signal to noise ratio by a factor of 20 to 60 dB. This is a very substantial improvement in the detectability of impulsive noise.

Many impulsive disturbances have amplitudes that are far greater than those of the excitation pulses. However in general there will also be some impulses whose amplitude is comparable with or even smaller than that of the excitation pulses. This may cause false detection of genuine excitation pulses as a noise pulse if the threshold level of a detector is chosen low enough to detect small amplitude impulses. The detectability of the impulsive disturbances may be improved by the process of inverse filtering which has the effect that the original signal $x_m$ is transformed to the uncorrelated excitations signal $e_m$, whereas the impulsive noise is smeared to a scaled version of the $(p+1)$ point inverse filter impulse response. Assuming that the excitation is Gaussian, a filter matched to the inverse filter impulse response may therefore optimally detect the smeared impulsive noise from the excitation signal.

Samples which are obliterated by impulses are discarded and replaced by signals based on the autoregression model based interpolation. As audio signals are non-stationary, it is necessary to make the threshold of the detector an adaptive function of the time varying excitation power estimate. In this connection the threshold is derived by passing the excitation through a data adaptive non-linear system, which is unity for small amplitude samples but introduces attenuation as the excitation sample amplitude exceeds some data dependent threshold.

The combination of impulse noise detection and suppression followed by adaptive noise suppression has been successfully applied to the restoration of archived recordings where two or recordings of an original performance exist.

It has been found with some archived records that the audio signal has been recorded on both left and right hand sides of the gramophone record groove walls. Experiments have shown that the impulsive and white noise disturbances from the left and right tracks are largely uncorrelated and by using a stereo pick-up in place of a mono pick-up, so two independent electrical signals can be obtained, one relating to the information to the left hand wall and the other from the right hand wall of the gramophone groove. Using the two signals so obtained and processing both signals through an impulsive noise detection system such as shown in Figure 2 and then processing both signals through an adaptive noise suppression system as shown in Figure 1, (the two signals being supplied to the inputs 10 and 16), an output signal which is substantially free of all noise can be obtained at junction 32.

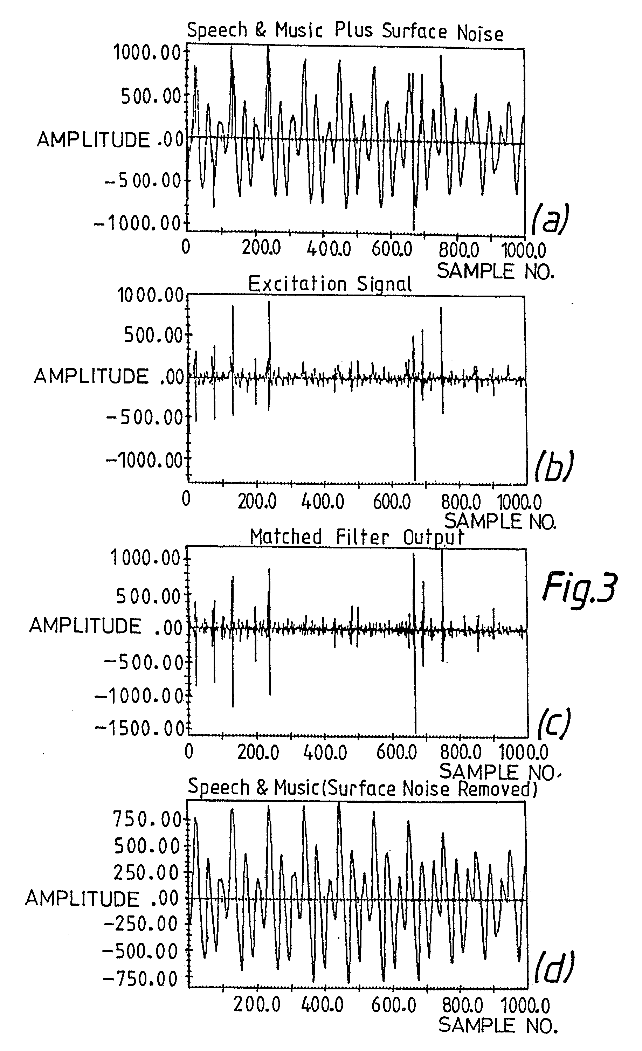

Figures 3, 4, 5 and 6 illustrate signals at different points in the impulse noise detection and suppression circuit of Figure 2 and are as follows:

Figure 3 shows the signal corrupted by impulsive noise,

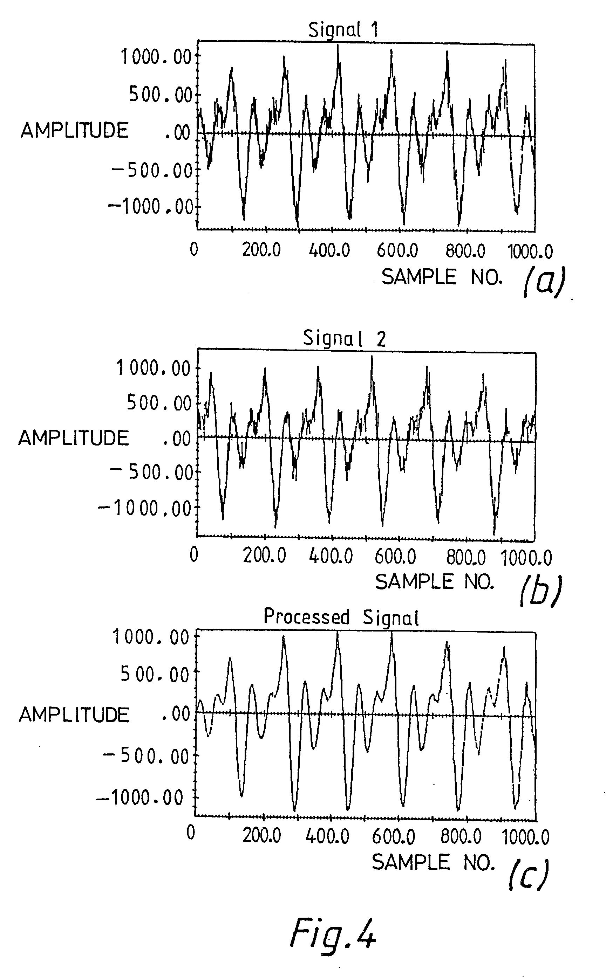

Figure 4 shows the excitation signal,
Figure 5 shows the matched filter output and
Figure 6 shows the restored signal.

The signal shown in Figure 6 may still include a lot of surface noise and high frequency component modulation and Figures 7 and 8 illustrate the two signals obtained from two impulse noise detection and suppression systems which originate from two recordings played simultaneously (or from a single record played through a stereo pick-up) and Figure 9 shows the final processed signal in which all noise has been removed.

It is to be understood that the examples of sound wave illustrated in Figures 3 to 6 are quite different from the examples illustrated in Figures 7, 8 and 9 and the different examples are intended to be merely illustrative of signals capable of being processed and enhanced.

A convenient apparatus for realising the system of Figure 1 comprises the NEC floating point signal processor board as supplied by Loughborough Sound Images Ltd.

## Claims

1. A method of noise reduction according to which two versions of the same original signal are processed simultaneously and wherein one incoming signal is processed by a digital or low pass analogue filter, the output of the filter is compared with the other incoming signal, an error signal is produced corresponding to the difference between the output of the filter and the other incoming signal, the error signal is processed by a microprocessor programmed with an adaptive algorithm so as to vary the characteristics of the filter, and said processing is effected to shift the filtered signal in time so as to reduce the error signal to a minimum, whereby the output of the digital filter provides a noise reduced and enhanced signal.

2. A method according to Claim 1, wherein the filter does not introduce a delay into the filtered signal greater than the filter length.

3. A method according to Claim 2, wherein additional relative delay is provided by the insertion of at least one pure delay devices in one of the inputs, whereby to maintain the relative delay within the filter length.

4. A method according to Claim 3, wherein the delay inroduced by the digital filter is approximately one half the filter length.

5. A method according to Claim 3, wherein the filter coefficients of the digital filter are shifted in the appropriate direction to avoid undesirable transients.

6. A method according to Claim 1, including a digital filter the coefficients of which are so adapted by the processing that the mean squared error is minimised.

7. A method according to Claim 6, wherein, for accurate estimation of the delay, a quadratic interpolater is used to determine values from three points at and around the maximum.

8. A method according to Claim 6, wherein the algorithm employed for implementation of the least squares filter is one of the LMS and the RLS algorithm.

9. A method according to Claim 8, using an LMS algorithm, wherein the input signal to the filter is modelled as the output of an auto-regressive system excited with a flat spectrum excitation.

10. A method according to Claim 8, using an RMS alogorithm, wherein filtering is commenced with the filter in a near to optimal initial condition, and the algorithm is periodically re-initialised, the re-initialisation period taking place substantially before the filter coefficients become corrupted, and the filter tap coefficients immediately before re-initialisation being used as the initial conditions.

$z(m) = x(m) + n1(m)$

10 ○ —————— | D | 12

$y(m) = x(m+\tau) + n2(m)$

16 ○ —————— | FIR Filter | 18

14 ⊕ $e(m)$

OUTPUT = $x = (m-M)$ ○ 32

| Adaption Algorithm | 20

*Fig.1*

$y = x + d$

○ ——————————— | Interpolator | 30 $x$ ○

| LPC Analysis | 24

$a$

| Inverse Filter | 22 $v$ | Matched Filter | 26 | Threshold Detector | 28 $z$ ○

*Fig.2*

Speech & Music Plus Surface Noise

(a)

Excitation Signal

(b)

Matched Filter Output

(c)

Fig.3

Speech & Music(Surface Noise Removed)

(d)

Fig.4